# EUROPEAN PATENT APPLICATION

(11) **EP 1 220 391 A1**
(43) Date of publication of application: **03.07.2002**
(21) Application number: 00128600.4
(22) Date of filing: 28.12.2000
(51) Int. Cl.: H01S 5/022, H01L 23/02

(54) **Package with thermoelectric cooler**

(71) Applicant: Corning O.T.I. S.p.A., 20126 Milano (IT)
(72) Inventor: Shaw, Mark Andrew, 20154 Milano (IT)
(74) Representative: Grunfeld, David Peter

(57) **Abstract**

The invention relates to a method for electrically connecting a thermoelectric cooler within a package to external terminal pins through at least a connecting lead, said method comprising the steps of:
(a) providing at least a metallised pad at a surface of the thermoelectric cooler;
(b) bonding one end of said connecting lead to the said metallised pad of the thermoelectric cooler;
(c) bonding the other end of said connecting lead to the external terminal pins,
wherein bonding of step (c) uses the parallel gap welding technique. Connecting leads can be either ribbons or wires.

## Description

### BACKGROUND OF THE INVENTION

### Field of the invention

The invention relates to the field of packages for opto-electronic and semiconductor devices and in particular to those packages with pins for external terminal connections formed on the package walls. This invention finds application in thermally controlled packages housing high-power devices, such as active opto-electronic devices.

### Description of related art

In the packaging of active opto-electronic devices the traditional method of packaging has been to use a semi-hermetic or hermetic metallic package with external terminal pins fixed to the package walls. Glass or ceramic sealing around terminal pins, which pass through apertures in the package wall, can fix the terminal pins to the package, thereby forming hermetically sealed electric feed-through's (seal-around technology). Presently, 14-pins butterfly packages have become standardised throughout the industry for opto-electronic packaging, e.g., for 980nm pump laser devices, since it enables customers to source from more than one supplier. This design with standard position of pin-out has lead to the development of ceramic terminal feed-through's, which extend through the side walls of the package and which comprise metallised bonding pads printed on the surface of a ceramic block. A plurality of terminal pins is provided on the portion of the bonding pads external to the package.

In case of high-power opto-electronic devices, such as laser diodes, light-emitting diodes or avalanche photodiodes, cooling of the semiconductor device is required in order to stabilise the temperature during operation and thus the optical or electrical signal output. Thermal stabilisation is normally achieved by using a thermoelectric cooler (TEC) in thermal contact with the high-power opto-electronic device. In semiconductor laser packages, the laser diode unit is generally mounted on cooling elements that use the Peltier effect for cooling, herein after referred to as Peltier cooler. The Peltier cooler needs to be electrically connected to the package terminal pins. Since drive currents of the Peltier cooler are typically of the order of the ampere, thick leads are necessary to connect the cooler to the terminal pins. Hereafter the leads used to connect the TEC to the terminal pins will be referred to as the TEC leads. To give numerical examples of the order of magnitude of the drive currents flowing in the TEC leads, a Peltier cooler mounting a 980nm pump laser can work with currents up to 1.8 A or even higher. A Peltier cooler mounting a high-power broad area laser, such as a multimode laser for Raman amplifiers, needs to have a stronger cooling action and can require operational currents as high as 8 A.

Electrical connections from the Peltier cooler to the external terminal pins have been generally performed by soldering of the TEC leads. Conventionally, hand soldering iron using soldering flux to assist the flow of the solder has been used. An example of the flux-assisted soldering method is described in Japanese patent application JP 8-064712.

During soldering, the flux leaves residues that contaminate the surfaces of the package. When contamination deteriorates the device performances, such as in the case of high power lasers, a fluxless bonding process has to be used instead of flux-assisted soldering. Examples of methods for connecting the TEC leads by fluxless soldering, hereafter referred to as welding or bonding, are given as follows.

Japanese patent application No. 11-054806 discloses a Peltier cooler having a top ceramic substrate that is provided with electrode pads. These electrode pads are connected to the bonding pads of the package ceramic feed-through through Au wires welded by wire bonding.

It is noteworthy that wire bonding generally refers to the techniques of ball bonding or of wedge bonding.

In US patent No. 5195102 metallised pads are present on the bottom ceramic plate of the Peltier cooler. Metallised pads are connected to the electrode patterns of a package ceramic feed-through by using flying leads bonded to the pads by wedge bonding using a standard wedge bonding machine.

US patent No. 5907185 describes the connection of TEC leads to electrode patterns printed on a ceramic terminal feed-through of a laser package, where inward leads projecting inside the package are fixed on grooves of the electrode patterns. Peltier leads are fixed to the inward leads by resistance welding.

The inventors have made the following observations.

The solution proposed in US5907185 consists in attaching an inward lead on the bonding pad of the ceramic terminal block and then to weld the TEC lead to the inward lead by resistance welding. Resistance welding cannot be used when TEC leads are to be welded directly to bonding pads on a ceramic feed-through. When using a resistance welding apparatus, the object(s) to be welded are placed between two welding electrodes, which are positioned opposite to each other, thus making bonding of a lead on a ceramic block impossible.

Wire bonding techniques such as those described in the above-mentioned prior art are used for connecting the TEC leads onto the bonding pads of a ceramic feed-through, as shown in US5195102. However, inventors have found out that using wire bonding for this purpose presents disadvantages. In ball bonding the end of the wire to be welded passes through a bonding tool (capillary). A ball is formed at the end of the wire and it is pressed against the bonding pad. The capillary then threads the wire to a spaced apart second bonding pad (or a lead) by a looping path and the wire is pressed onto the second pad. As the capillary lifts away from the pad, the wire is pulled apart, leaving the wire tip protruding for the next bonding cycle. Similarly to ball bonding, wedge bonding is generally used to provide two discrete bonds with a wire being bonded to a first point, being looped and then bonded to a second point. In the case of wedge bonding a wedge is formed at the wire tip by pressing the wire against the pad.

Conventional ball bonding and wedge bonding tools are developed for input/output contacts of integrated circuits and are limited to wire diameters not larger than about 70-80 µm. In addition, ball bonding is applicable to wires and not to ribbons. In present high-power applications, TEC wires need to be of a diameter larger than 80 µm. Wire bonding becomes therefore unsuitable for connecting TEC leads.

Ribbons can be used in wedge bonding tools, but generally their thickness cannot be larger than 25 µm. Wedge bonding tools bond in only in one direction. Wire bonding becomes troublesome when the looping path of the threaded wire (or ribbon) occurs between two points situated at different heights and with a small lateral distance from each other. The movement envelope of the wedge bonding (or ball bonding) tool, which has to be moved down (or up) to the second point following a looping path, makes welding problematical. This is in fact the case of welding TEC leads from an electrode pad situated on the TEC bottom substrate to a terminal feed-through on the side package wall. The height difference can be well over 3 mm.

Pre-soldering of the TEC leads on the TEC substrate prior to the assembly of the TEC into the package can obviate the problem of connecting two points situated at different heights. In this way welding of the TEC lead would occur only at the terminal package feed-through. However, wire bonding methods are not for single-point welding and a different bonding technique must be used.

We remark that although the method proposed in JP11054806 overcomes the problem of wire bonding the TEC leads from the bottom of the package, said method has the disadvantage that bonding is done on the cooling surface of the top substrate of the Peltier. Welding can induce heating of the Peltier elements with consequent detrimental effect of their cooling performances. It is important to note that risk of a thermal short circuit of the package is not negligible because of the relatively large dimension of the TEC leads.

European patent application No. 0171877 describes a method of securing leads to planar metallic electrodes of a thermistor by parallel gap welding. Japanese patent application No. 7-214295 discloses a method of connecting a lead wire to a thin-film electrode by parallel gap welding. A metallic block is interposed between the electrode and the lead wire to prevent the melting of the electrode.

### SUMMARY OF THE INVENTION

The inventors have found out that parallel gap welding provides a suitable method for connecting TEC leads to the external terminal pins of a package.

The present invention provides a method of connecting the TEC leads to external terminal pins by a welding technique that can easily cope with different relative orientations and positions of the package and the TEC. More particularly, the present invention provides a method that is applicable to any height difference, which may exist between the metallised pads of the Peltier cooler and the package feed-through's.

The invention relates to a method for electrically connecting a thermoelectric cooler within a package to external terminal pins through at least a connecting lead, said method comprising the steps of:
(a) providing at least a metallised pad at a surface of the thermoelectric cooler;
(b) bonding one end of said connecting lead to the said metallised pad of the thermoelectric cooler;
(c) bonding the other end of said connecting lead to the external terminal pins,
wherein, bonding of step (c) uses the parallel gap welding technique. Connecting leads can be either ribbons or wires.

The present invention provides also a method for welding the TEC leads to the terminal pins, these leads being soldered at one end to the TEC substrate prior to the assembly of the TEC into the package. Preferably, assembling of the thermoelectric cooler within the package occurs before step (c).

If assembling of the TEC within the package occurs prior to bonding of the TEC leads on the metallised pads of the TEC substrate, i.e., between steps (a) and (b), parallel gap welding can be used for the bonding of the TEC leads to the metallised pads of the TEC substrate.

Preferably, said connecting lead is bonded to the external terminal pin by means of a ceramic terminal feed-through, said ceramic terminal feed-through extending through the package wall and comprising at least a bonding pad on a ceramic block, this bonding pad extending through the package wall, wherein the connecting lead is bonded to the surface of the internal portion of said bonding pad and the external terminal pin is fixed on the external portion of said bonding pad. Herein, with internal and external portions of the ceramic feed-through we mean internal and external portion with respect to the package..

A metallic plate can be applied prior to bonding an end of the connecting lead to the bonding pad of the ceramic terminal feed-through, i.e., prior to step (c). Alternatively, the metallic plate can be applied prior to bonding one end of the connecting lead to the said metallised pad of the thermoelectric cooler on the metallised pad of the thermoelectric cooler. Said metallic plate can be made of a material selected from Kovar and steel.

The invention has also to do with a package provided with external terminal pins for housing a thermoelectric cooler, wherein said terminal pins are fixed on the external portion of a ceramic terminal feed-through, said ceramic terminal feed-through extending through the package wall and comprising at least a bonding pad on a ceramic block, this bonding pad extending through the package wall. The ceramic terminal feed-through comprises a metallic plate attached on the surface of the internal portion of said bonding pad, said metallic plate being of a dimension not exceeding that of the ceramic block. The metallic plate should not extend outside the ceramic block so as it can withstand any force applied by welding electrodes during parallel gap welding.

### BRIEF DESCRIPTION OF THE DRAWINGS

FIG. 1 is a partial perspective view of an opto-electronic package showing the arrangement where TEC leads are ribbons.
FIG. 2 is a partial perspective view of the opto-electronic package having the arrangement of FIG. 1 showing welding electrodes.
FIG. 3 is a partial perspective view of the opto-electronic package showing the arrangements where TEC leads are wires.

### DESCRIPTION OF PREFERRED EMBODIMENTS

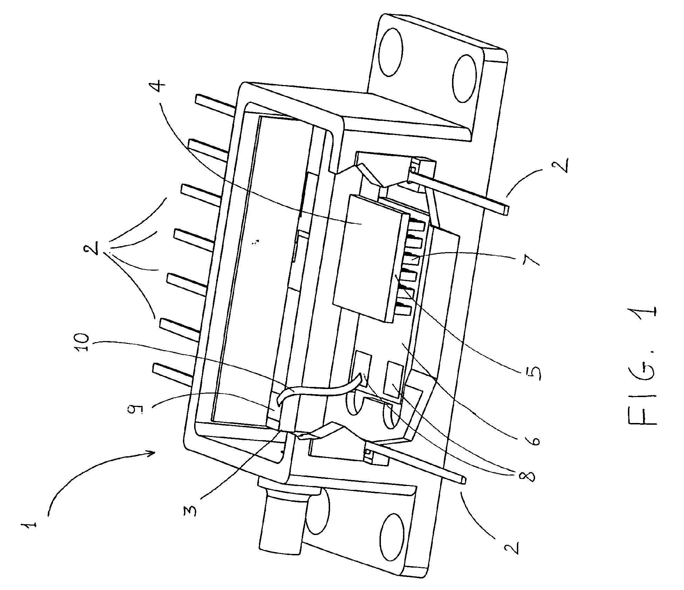

Figure 1 shows the first preferred embodiment of the invention. A package 1 comprises external pins 2 bonded, e.g., by co-firing or brazing, on the external portion of bonding pads 9 of a ceramic terminal feed-through 3. The package houses a TEC, in this case a Peltier cooler 4, comprising a top ceramic substrate 5, Peltier cooling elements 7 and a bottom ceramic substrate 6 having metallised pads 8. Metallised pads 8 are preferably gold (Au) plated. One or more opto-electronic devices (not shown) can be placed on the top substrate 5 of the Peltier cooler for thermal dissipation. Ribbons 10 are attached to the metallised pad 8 by parallel gap welding (only one ribbon is shown in the drawing). Ribbon 10 should have a size suitable to carry relatively high drive currents. For example, if the maximum current of the TEC is about 2 A and ribbon is 10 mm long, a gold ribbon 10 with a width x thickness of 250x25 µm² can be used for the purpose. The other end of the ribbon 10 is attached to a bonding pad 9 of the ceramic terminal block 3, also using parallel gap welding.

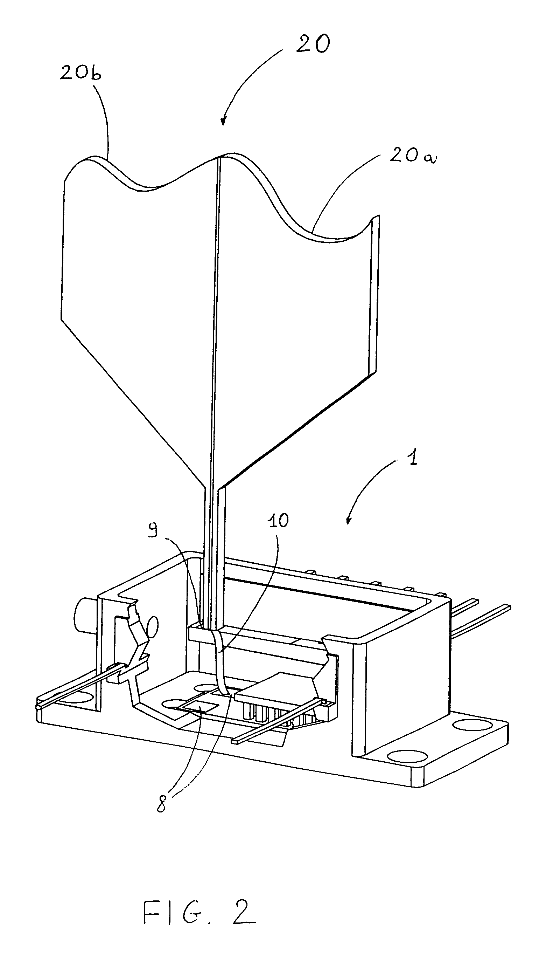

Figure 2 shows welding of TEC leads according to the invention. A parallel gap welding machine (not shown) comprises two parallel electrodes 20a and 20b. Current flows through the two electrodes 20a and 20b in the ribbon 10 so that welding of the ribbon to the bonding pad 9 takes place. An example of commercial parallel gap welding machine suitable for bonding a 250 x 25 µm² ribbon is Unitek Unibond II with model 50 light force weld head. In this specific example, welding can be carried out by using a head force of 320 gms and a voltage of 0.8 V for 10 ms.

It is to be understood that ribbons need to be of a larger width (and/or thickness) in case the TEC leads carry higher maximum currents, such as in the case of power dissipation of multimode lasers for Raman amplification. The choice of suitable ribbon dimensions depends on the maximum operating current of the TEC and on the length of the ribbons, as longer ribbons need to have a larger width and/or a larger thickness in order to carry the same maximum current.

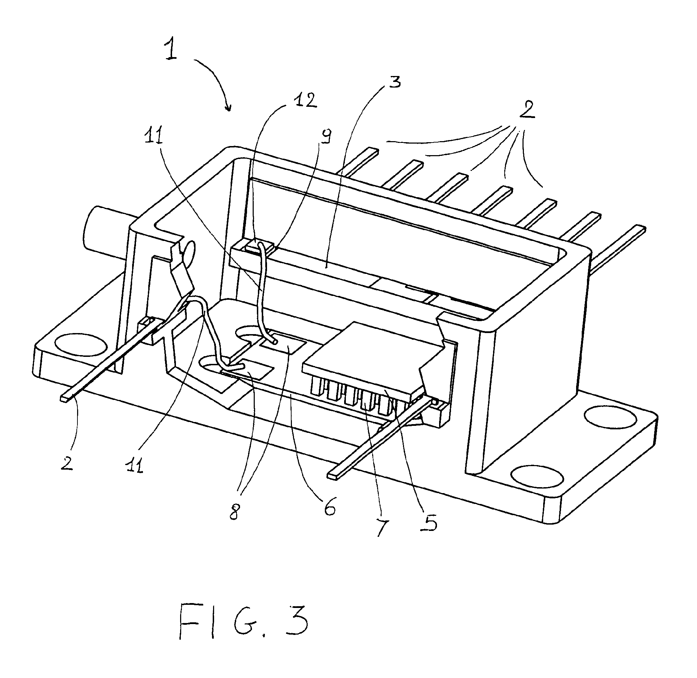

Table I shows some examples of minimum allowable dimensions of TEC leads for different maximum allowable currents of the TEC for two different lengths of the leads, as inferred from calculations according to the model of G.T. Nöbauer and H. Moser described in *"Analytical approach to temperature evaluation in bonding wires and calculations of allowable currents",* IEEE Transactions on Advanced Packaging vol. 23, p. 426-35, August 2000. The maximum allowable current is defined in this context as the current corresponding to the melting temperature of the lead metals (gold or nickel in our examples), i.e., when rupture of the leads occurs. Examples with wires refer to the second embodiment of the present invention, which will be described with reference to Fig. 3. For ribbons, width values refer to a thickness of 25 µm. Preferably, to have a 50% margin of safety, dimensions are chosen to be larger than the minimum dimensions for a maximum allowable current which is twice the actual operational current.

**TABLE I**

| Max current | Length | Au ribbon width | Au wire diameter | Ni wire diameter |
|---|---|---|---|---|
| (A) | (mm) | (µm) | (µm) | (µm) |
| 2 . | 10 | 106 | 58 | 112 |
| 2 | 4 | 43 | 37 | 70 |
| 4 | 10 | 206 | 81 | 158 |
| 4 | 4 | 82 | 51 | 100 |
| 8 | 10 | 415 | 115 | 221 |
| 8 | 4 | 162 | 72 | 140 |

In the arrangement described with reference to FIG. 1, bonding of ribbon 10 to pads 8 and 9 occurs after installing the TEC in the package. In the preferred embodiment, the Peltier device has a bottom ceramic substrate 6 larger than the top ceramic substrate 5, at least in the direction where metallised pads are formed. The exceeding length should provide enough space for the parallel gap electrodes to reach the electrode pads 8 without interfering with Peltier elements 7 or other components mounted on top of the Peltier cooler.

It is to be appreciated that if ribbon 10 is attached to electrode pads 8 prior to the assembly of the Peltier cooler in the package, a shorter bottom ceramic substrate 6 could be used. In this case the ribbon is bonded by parallel gap welding to bonding pads 9 after the installation of the Peltier cooler in the package.

Figure 3 illustrates the second embodiment of the present invention. Instead of ribbons, TEC leads consist of wires 11. Wires 11 can be fixed to metallised pads 8 prior to assembly of the Peltier cooler 4 in the package. In this case, fixing of the wires 11 to the Peltier could be done using a conventional soldering or welding technique. Once the Peltier cooler is assembled in the package, wires 11 are bonded to bonding pads 9 of the ceramic terminal feed-through 3 using the parallel gap welding technique.

During parallel gap welding of wires 11 to bonding pads 9, damage could be induced to the ceramic block and/or to the parallel gap electrodes of the welding tool because of the high currents required for welding thick wires. To prevent deterioration of the ceramic block, a metallic plate 12 can be attached on the bonding pad 9 of the ceramic feed-through prior to welding, e.g., at the same time as the package manufacture. This metallic plate helps dissipating the current needed to fuse thick wires 11 during parallel-gap welding operation. Metallic plate 12 may be made of a metallic material that ensures a good welding, such as Kovar or steel. The metallic plate can be attached to the bonding pad by co-firing. For example, for bonding a 0.2 mm-diameter nickel wire, the thickness of the metallic plate should be of at least 0.2 mm. A metallic plate can be used also in combination with ribbons (see previous embodiment), in particular with ribbons having a thickness larger than 25 µm. The dimension of the metallic plate should not exceed that of the ceramic block in order to withstand any force applied by the welding electrodes during parallel gap welding.

It is to be understood that if parallel gap welding is carried out on the TEC lead to the metallised pads of the Peltier cooler, e.g. after assembling of the cooler in the package, a metallic plate can be applied on the metallised pads 8 of the Peltier bottom substrate.

Although the above detailed description refers to a package for opto-electronic devices provided with a ceramic terminal feed-through, alternative embodiments can be considered without departing from the scope of the present invention. For instance, parallel gap welding of TEC leads can be performed in packages in which external terminal pins are hermetically sealed to the package walls with glass or ceramic paste (seal-around technology). In the case of sealed-around terminal pins, wires (or ribbons) can be bonded to the terminal pins by parallel gap welding without the need of a metallic plate. A metallic plate can be applied to the metallised pads of the TEC substrate.

This method can be used also in dual in-line packages.

In addition to packages housing opto-electronic devices, the described method can be used in any package housing at least a semiconductor electronic device (not necessarily an opto-electronic device) that needs thermal dissipation, i.e., packages including a thermoelectric cooler. The invention can be extended also to packages housing integrated circuits chips.

The above detailed description is only illustrative of the invention, which is not restricted to the preferred embodiments. Modifications and equivalents will be obvious to those with skill in the art and will not depart from the scope of the invention as it is defined by the following claims.

## Claims

1. A method for electrically connecting a thermoelectric cooler within a package to external terminal pins through at least a connecting lead, said method comprising the steps of:
(a) providing at least a metallised pad at a surface of the thermoelectric cooler;
(b) bonding one end of said connecting lead to the said metallised pad of the thermoelectric cooler;
(c) bonding the other end of said connecting lead to the external terminal pins,
wherein
bonding of step (c) uses the parallel gap welding technique.

2. The method of claim 1, wherein bonding of step (b) uses the parallel gap welding technique.

3. The method of claim 1, further comprising between steps (a) and (b) the step of assembling the thermoelectric cooler within the package.

4. The method of claim 1, further comprising, before step (c), the step of assembling the thermoelectric cooler within the package.

5. The method of any of the preceding claims, wherein said connecting lead is bonded to the external terminal pin by means of a ceramic terminal feed-through, said ceramic terminal feed-through extending through the package wall and comprising at least a bonding pad on a ceramic block, this bonding pad extending through the package wall, wherein
the connecting lead is bonded to the surface of the internal portion of said bonding pad and the external terminal pin is fixed on the external portion of said bonding pad.

6. The method of any of the preceding claims, wherein said connecting lead is a ribbon.

7. The method of any of the claims 1 to 5, wherein said connecting leads is a wire.

8. The method of any of claims 5 to 7, wherein a metallic plate is applied prior to step (c) on the internal portion of the bonding pad of the ceramic terminal feed-through.

9. The method of any of the preceding claims, wherein a metallic plate is applied prior to step (b) on the metallised pad of the thermoelectric cooler.

10. The method of claim 8 or 9, wherein said metallic plate is made of a material selected from Kovar and steel.

11. A package for housing a thermoelectric cooler prepared by the method of at least one of the preceding claims.

12. A package provided with external terminal pins for housing a thermoelectric cooler, wherein
said terminal pins are fixed on the external portion of a ceramic terminal feed-through, said ceramic terminal feed-through extending through the package wall and comprising at least a bonding pad on a ceramic block, this bonding pad extending through the package wall; and
said ceramic terminal feed-through further comprises a metallic plate attached on the surface of the internal portion of said bonding pad, said metallic plate being of a dimension not exceeding that of the ceramic block.
